# DEMANDE DE BREVET EUROPEEN

(11) **EP 4 793 757 A1**
(43) Date de publication de la demande: **19.08.2026**
(21) Numéro de dépôt: 26158035.1
(22) Date de dépôt: 12.02.2026
(51) Int. Cl.: G06F 7/58, G11C 11/16, G11C 11/18

(54) **CONTROLE DE LA SORTIE D'UN DISPOSITIF SPINTRONIQUE A BIT PROBABILISTE**

(30) Priorité: 13.02.2025 FR 2501505
(71) Demandeur: Commissariat à l'Energie Atomique et aux Energies Alternatives, 75015 Paris (FR); Centre National de la Recherche Scientifique, 75016 Paris (FR); Université Grenoble Alpes, 38400 Saint-Martin-d'Hères (FR); Institut Polytechnique de Grenoble, 38000 Grenoble (FR)
(72) Inventeur: DANOUCHI, Kamal, 38054 Grenoble Cedex 09 (FR); HUTIN, Louis, 38054 Grenoble Cedex 09 (FR); PRENAT, Guillaume, 38054 Grenoble Cedex 09 (FR)
(74) Mandataire: Atout PI Laplace

(57) **Abrégé**

L'invention a pour objet un procédé de fabrication d'un dispositif spintronique (D1) comprenant :
- une jonction tunnel magnétique (MTJ) ;
- un transistor de polarisation (Tₚₒₗ) monté en série avec la jonction tunnel magnétique (MTJ) ;
- un circuit de détection (DET) ayant une entrée (e_{det}) connectée à un premier nœud de détection (NC1) et une sortie (s_{det}) pour générer un signal de détection (Vₒᵤₜ) ; le circuit de détection comprenant au moins un premier inverseur (INV1) comprenant un premier transistor NMOS (T_{INV1,N}) et un second transistor PMOS (T_{INV1,P}) ayant chacun :
∘ une grille avant (G_{1,N ,}G_{1,P}) ;
∘ une grille arrière (G_{2,N ,}G_{2,P}) formée par une couche isolante (BOX) enterrée dans un substrat semi-conducteur (2) ;

- un circuit de contrôle (CONT) configuré pour appliquer une tension de commande (V_{cmd}) non-nulle sur la grille arrière (G_{2,N ,}G_{2,P}) d'au moins l'un parmi le premier ou le second transistor.

## Description

L'invention concerne un dispositif spintronique à bit probabiliste (communément appelé p-bit) basé sur une unité stochastique consistant en une jonction tunnel magnétique. Plus particulièrement, l'invention concerne une architecture particulière de détection de l'état de l'unité stochastique permettant de la configurer entre une configuration fluctuante ou une configuration forcée à un état logique prédéterminé.

Un générateur de bit probabiliste est un dispositif qui génère une série de bits (sorties binaires de type 0 ou 1) de manière aléatoire en se basant sur des phénomènes physiques ou quantiques, assurant ainsi un niveau d'aléa ou d'entropie déterminé. Contrairement aux dispositifs classiques qui produisent des résultats déterministes, ce type de dispositif produit un 0 ou un 1 selon une probabilité ajustable en fonction des besoins de l'application. Ce type de sortie probabiliste est essentiel dans des domaines tels que la cryptographie, les algorithmes probabilistes et les simulations, où la génération de valeurs binaires aléatoires garantit la sécurité ou la représentativité des calculs. Cela signifie qu'au lieu de donner systématiquement un 0 ou un 1 de manière déterministe, le dispositif génère une série de bits pendant une durée prédéterminée dans laquelle la distribution entre des bits de 0 et des bits de 1 peut être contrôlée ou prédéfinie via des paramètres d'entrée. Par exemple, on pourrait définir une probabilité de 0,7 pour obtenir un 1 et de 0,3 pour obtenir un 0, ce qui produirait une distribution dans une série de bits (bit word en anglais) où environ 70 % des bits sont des 1 et 30 % sont des 0. Cette distribution probabiliste distingue le générateur de bit probabiliste des générateurs de nombres pseudo-aléatoires, car il s'appuie sur des sources d'incertitude physique (comme le bruit quantique ou thermique ou magnétique), produisant un véritable aléa au niveau des bits.

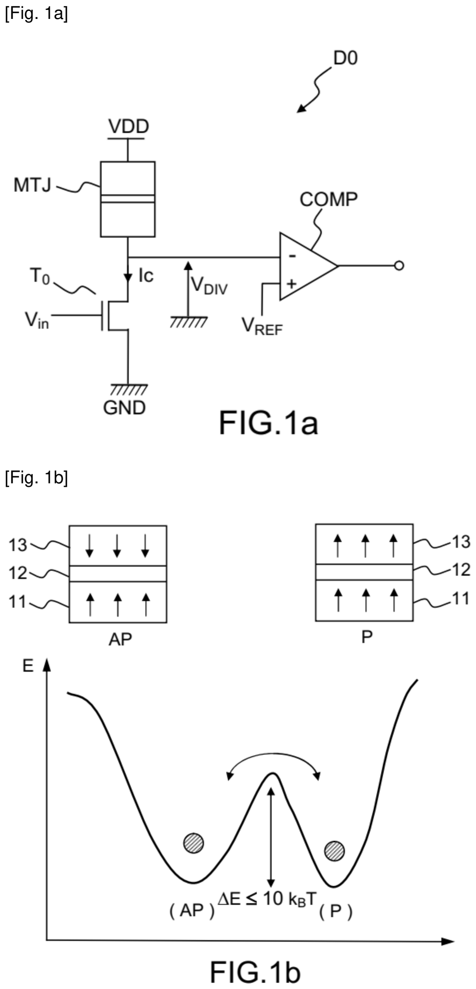

Les dispositifs générateurs de bit probabiliste à base de jonction tunnel magnétique présentent une solution prometteuse pour exploiter les fluctuations de l'état de polarisation magnétique dans une telle structure. La figure 1a illustre le schéma électrique d'un générateur de bit probabiliste D0 selon l'état de l'art. Le générateur de bit probabiliste D0 comprend une jonction tunnel magnétique MTJ, un transistor de contrôle T₀ et un comparateur COMP. La jonction tunnel magnétique MTJ est un pilier magnéto résistif comprenant un empilement de couches 11,12,13. L'empilement comprend une première couche 11 ferromagnétique dans laquelle la direction de la polarisation magnétique est fixe et uniforme. L'empilement comprend en outre une seconde couche 13 ferromagnétique dans laquelle la direction de la polarisation magnétique est variable. L'empilement comprend en outre une couche barrière 12 d'oxyde confinée entre la première et la seconde couche ferromagnétique 11,13. La couche barrière 12 joue un rôle crucial dans l'effet tunnel magnétorésistif, permettant aux électrons de traverser par effet tunnel quantique. La première couche ferromagnétique 11 sert de référence pour détecter les changements de magnétisation dans la couche ferromagnétique libre 13. Le principe de fonctionnement du pilier MTJ magnétorésistif repose sur le changement de la résistance électrique en fonction de l'orientation de polarisation magnétique de la couche ferromagnétique libre 13 par rapport à celle dans la couche ferromagnétique de référence 11 référence. Lorsque les aimantations des couches libres et de référence 11,13 sont parallèles, la résistance électrique est faible et on parle d'un état résistif bas P. Lorsque les aimantations sont antiparallèles, la résistance électrique est élevée et on parle d'un état résistif haut AP. Le dimensionnement de la jonction tunnel magnétique MTJ est tel que les moments magnétiques des couches fluctuent entre différentes orientations sous l'influence des fluctuations thermiques, même en l'absence de champ magnétique externe. Ces fluctuations sont suffisamment importantes par rapport à la barrière d'énergie qui sépare les deux états résistifs, pour que la magnétisation ne soit plus stable dans une direction fixe. On parle ici d'un fonctionnement en « régime de fluctuation » ou d'un état « superparamagnétique », contrairement aux mémoires magnétorésistives où les couches magnétiques conservent leur orientation suite à une programmation. En effet, dans une mémoire magnétorésistive barrière d'énergie entre les deux états résistifs est hors de portée l'énergie thermique avec une amplitude supérieure à 40xk_{b}T avec k_{b} la constante de Boltzmann et T la température du fonctionnement de la mémoire. Le fonctionnement de la jonction tunnel superparamagnétique MTJ est illustré par le diagramme d'énergie de la figure 1b qui illustre un premier état résistif P et un second état résistif AP séparés par une barrière d'énergie ΔE inférieure ou égale à dix fois l'énergie thermique k_{b}T, avec k_{b} la constante de Boltzmann et T la température du fonctionnement du générateur D0. La probabilité respective de génération de bits 0 (état résistif haut ou inversement selon la convention choisie) et de bits 1 (état résistif bas ou inversement selon la convention choisie) par la jonction tunnel magnétique MTJ dépend de l'intensité du courant de polarisation Ic qui la traverse. L'intensité du courant Ic est régulée par le transistor de contrôle T₀ monté en série avec la jonction tunnel magnétique MTJ entre un nœud d'alimentation fournissant la tension d'alimentation VDD et la masse électrique GND. Le nœud commun entre la jonction tunnel magnétique MTJ et le transistor de contrôle T₀ forme un premier nœud de détection NC1. Le comparateur COMP est configuré pour comparer la chute de tension à travers la jonction tunnel magnétique, correspondant au potentiel électrique V_{DIV} du premier nœud de détection NC1, avec une tension de référence V_{REF}, pour déterminer en continu l'état résistif aléatoire de ladite jonction tunnel magnétique.

Le courant de polarisation Ic est commandé par la tension d'entrée Vᵢₙ appliquée sur la grille du transistor de contrôle T₀. La tension d'entrée Vᵢₙ est avantageusement choisie de manière à fonctionner en régime linéaire ou en régime ohmique. L'augmentation de la tension d'entrée Vᵢₙ engendre l'augmentation du courant de polarisation Ic. L'augmentation du courant de polarisation Ic induit l'augmentation de la probabilité P(1) d'avoir un état résistif haut AP (équivalent à un bit « 1 » de manière conventionnelle non limitative). Inversement, la diminution du courant de polarisation Ic induit l'augmentation de la probabilité P(0) d'avoir un état résistif bas P (équivalent à un bit « 0 » de manière conventionnelle non limitative).

Les calculateurs stochastiques présentent une application importante des générateurs de bit probabiliste. Un calculateur stochastique basé sur un réseau de p-bits est une architecture computationnelle innovante qui comprend une pluralité de générateurs de bit probabiliste (p-bits) interconnectés pour former un réseau. Le p-bit généré de chaque générateur influence les p-bits des autres générateurs via des poids de connexion, de manière similaire aux réseaux de neurones ou aux modèles physiques tels que le modèle d'lsing. Cette approche permet de simuler des systèmes physiques complexes, de résoudre des problèmes combinatoires et d'effectuer des calculs logiques approximatifs, souvent avec une grande efficacité énergétique.

Pour réaliser des opérations de calcul spécifiques, il est nécessaire de fixer (ou de forcer) la sortie de certains p-bits à 1 ou à 0. Cette opération est désignée par « clamping » de la sortie du générateur de p-bit. Par exemple, pour implémenter une opération logique AND entre deux p-bits A et B, on peut ajouter un troisième p-bit C dont l'état est influencé par les deux premiers. En forçant A et B à des états logiques prédéterminés (pas de fluctuation ici), le p-bit C peut être configuré pour osciller uniquement en fonction des règles de l'opération logique C=(A) AND (B). L'interaction entre ces p-bits est gouvernée par des poids synaptiques et des termes de biais. La mise à jour de C est déterminée par une fonction sigmoïde dépendant de la somme pondérée des entrées A et B. Cette opération de fixer certains p-bits permet au réseau de réaliser des calculs à variables fixes dans un cadre stochastique. Plus particulièrement, l'opération de clamping permet de résoudre différents sous-problèmes, représentant des cas particuliers de la configuration où tous les p-bits sont libres, à partir du même réseau physique. Par exemple , avec une fonction de circuit multiplicateur, il est possible de fixer les bits des facteurs pour faire une multiplication, ou de fixer les bits du produit pour faire une factorisation, ou de fixer des bits quelconques pour résoudre un problème de satisfaisabilité Booléenne quelconque.

Dans ce contexte, un problème technique majeur est rencontré, à savoir l'implémentation de l'opération de « clamping » dans un réseau constitué de plusieurs centaines de générateurs de bit probabiliste sans augmenter drastiquement la taille du calculateur stochastique ni sa consommation énergétique.

Une solution connue dans ce contexte consiste à rajouter pour chaque générateur de bit probabiliste un premier transistor « pull-up » qui connecte sa sortie à la tension d'alimentation lorsque activé et un second transistor « pull-down » qui connecte sa sortie à la masse électrique lorsque activé. L'inconvénient de cette solution consiste à une augmentation considérable de la taille d'un calculateur stochastique qui met en œuvre une pluralité de générateurs de bits probabiliste. L'ajout d'une paire de transistors par générateur de bit probabiliste augmente aussi les courants de fuite dans le calculateur stochastique ce qui induit une hausse de sa consommation énergétique.

Pour pallier les limitations des solutions existantes, l'invention propose un dispositif spintronique configuré pour produire une sortie forcée sur un état logique prédéfini selon une première configuration , ou pour générer des bits aléatoires ou pseudo-aléatoires avec une distribution contrôlée selon une seconde configuration. Il se distingue des générateurs classiques par une architecture de détection, reposant sur le contrôle du seuil de basculement d'au moins un inverseur dans la chaîne de détection. L'inverseur est réalisé par des transistors de type SOI, plus avantageusement FDSOI. Le contrôle est réalisé en appliquant une tension de commande sur les grilles arrière des transistors qui composent ledit inverseur. Cette solution facilite ainsi l'exécution de calculs impliquant des générateurs stochastiques dans un réseau de plusieurs centaines de générateurs probabilistes, tout en maintenant une taille compacte et une faible consommation énergétique pour le calculateur stochastique.

L'invention a pour objet Dispositif spintronique comprenant :
- une jonction tunnel magnétique ayant une résistance qui fluctue entre au moins deux états résistifs distincts selon sa magnétisation ;
- un transistor de polarisation monté en série avec la jonction tunnel magnétique ; le nœud commun entre le transistor de polarisation et la jonction tunnel magnétique constituant un premier nœud de détection ;
- un circuit de détection ayant une entrée connectée au premier nœud de détection et une sortie pour générer un signal de détection; le circuit de détection comprenant au moins un premier inverseur comprenant un premier transistor NMOS et un second transistor PMOS montés en série entre la masse électrique et un nœud d'alimentation fournissant une tension d'alimentation, et ayant chacun :
   ∘ une grille avant ;
   ∘ une grille arrière formée par une couche isolante enterrée dans un substrat semi-conducteur ;
   les grilles avant du premier et du second transistors recevant le potentiel du premier nœud de détection ou un signal intermédiaire généré à partir du potentiel du premier nœud de détection ;
- un circuit de contrôle configuré, selon une première configuration, pour appliquer une tension de commande non-nulle sur la grille arrière d'au moins l'un parmi le premier ou le second transistor pour fixer le signal de détection à la masse électrique ou à la tension du nœud d'alimentation selon le signe de la tension de commande.

Selon un aspect particulier de l'invention, le circuit de contrôle est configuré en outre, selon une seconde configuration, pour appliquer une tension de commande nulle sur la grille arrière d'au moins l'un parmi le premier ou le second transistor de sorte que signal de détection varie avec les fluctuations de la résistance de la jonction tunnel magnétique.

Selon un aspect particulier de l'invention, le premier transistor et le second transistor sont de type « silicium sur isolant totalement déserté ».

Selon un aspect particulier de l'invention, le circuit de contrôle est configuré pour appliquer la tension de commande simultanément sur les grilles arrière du premier transistor et du second transistor.

Selon un aspect particulier de l'invention, le circuit de détection comprend une chaine d'une pluralité d'inverseurs ; ladite chaine comprenant le premier inverseur.

Selon un aspect particulier de l'invention, le circuit de détection comprend un comparateur ayant une première entrée connectée au premier nœud de détection et une seconde entrée destinée à recevoir une tension de référence et un nœud de sortie connecté aux grilles avant du premier et du second transistor.

Selon un aspect particulier de l'invention, le premier nœud de détection est connecté aux grilles avant du premier et du second transistor.

Selon un aspect particulier de l'invention, le dispositif comprend en outre un circuit calculateur configuré pour générer un bit probabiliste à partir du signal de détection par échantillonnage ou par calcul de moyenne en déterminant la proportion de chaque état résistifs de la jonction tunnel magnétique pendant une période prédéterminée.

Selon un aspect particulier de l'invention, la jonction tunnel magnétique est une jonction tunnel super-paramagnétique.

Selon un aspect particulier de l'invention, la jonction tunnel magnétique est disposée sur une piste d'écriture en un matériau à effet Hall de spin ou un matériau à effet Hall orbital.

Selon un aspect particulier de l'invention, la jonction tunnel magnétique comprend :
- une première couche ferromagnétique de référence dans laquelle la direction de la polarisation magnétique est fixe ;
- une seconde couche ferromagnétique dans laquelle la direction de la polarisation magnétique est variable ;
- une couche barrière tunnel d'oxyde confinée entre la première et la seconde couche ferromagnétique.

Selon un aspect particulier de l'invention, l'épaisseur de la seconde couche est inférieure à 100 nm.

Selon un aspect particulier de l'invention, le diamètre de la jonction tunnel magnétique est inférieur à 10 nm.

L'invention concerne également un calculateur stochastique comprenant un réseau d'une pluralité de générateurs de bit probabiliste interconnectés, le réseau comprenant au moins un générateur de bit probabiliste réalisé par le dispositif spintronique selon l'invention.

D'autres caractéristiques et avantages de la présente invention apparaîtront mieux à la lecture de la description qui suit en relation aux dessins annexés suivants.
La figure 1a illustre un générateur D0 de bit probabiliste selon l'état de l'art. Cette figure a déjà été décrite.
La figure 1b illustre un diagramme d'énergie du générateur D0 de bit probabiliste selon l'état de l'art. Cette figure a déjà été décrite.
La figure 2a illustre un générateur D1 de bit probabiliste selon un premier mode de réalisation de l'invention.
La figure 2b illustre des vues en coupe de l'implémentation de quatre transistors différents de type FDSOI.
La figure 2c illustre la variation du signal de détection du générateur de bit probabiliste selon un premier mode de réalisation de l'invention en réponse à une variation de la tension de commande.
La figure 3 illustre un générateur D1 de bit probabiliste selon un deuxième mode de réalisation de l'invention.
La figure 4 illustre un générateur D1 de bit probabiliste selon un troisième mode de réalisation de l'invention.
La figure 5 illustre un générateur D1 de bit probabiliste selon un quatrième mode de réalisation de l'invention.

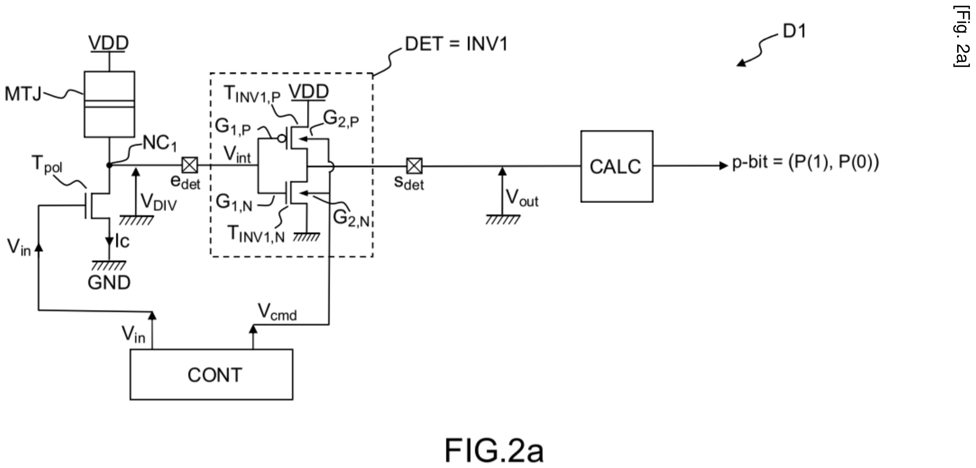

La figure 2a illustre un dispositif spintronique et plus particulièrement un générateur de bit probabiliste D1 selon un premier mode de réalisation de l'invention. Le générateur D1 de bit probabiliste p-bit comprend une jonction tunnel magnétique MTJ, un transistor de polarisation Tₚₒₗ, un circuit de détection DET, un circuit calculateur CALC et un circuit de contrôle CONT. La jonction tunnel magnétique MTJ est dimensionnée de manière à fonctionner en régime de fluctuation en réponse à l'agitation thermique. La jonction tunnel magnétique MTJ est formée par un empilement de couches. L'empilement comprend une première couche 11 ferromagnétique de référence dans laquelle la direction de la polarisation magnétique est fixe et uniforme. L'empilement comprend en outre une seconde couche 13 ferromagnétique dans laquelle la direction de la polarisation magnétique est variable. L'empilement comprend en outre une couche barrière 12 d'oxyde confinée entre la première et la seconde couche ferromagnétique 11,13. Le diamètre (ou la diagonale selon la forme) de la jonction tunnel magnétique MTJ est inférieur à 100 nm. Plus avantageusement, l'épaisseur de la seconde couche 13 est inférieure à 10 nm, de préférence inférieure à 5nm. Cela permet d'abaisser la barrière d'énergie séparant le premier état résistif P et le second état résistif AP à une valeur inférieure ou égale à dix fois l'énergie thermique k_{B}T et donc de réaliser une jonction tunnel super-paramagnétique MTJ. Pour rappel, une jonction tunnel super-paramagnétique présente un état résistif fluctuant où la magnétisation est instable sous l'influence thermique.

A titre illustratif non limitatif, le transistor de polarisation Tₚₒₗ est un transistor à effet de champs de type NMOS. Le transistor de polarisation Tₚₒₗ fonctionne comme une source de courant modulable configurée pour injecter un courant de commande Ic à travers la jonction tunnel magnétique MTJ de manière à contrôler la distribution entre les deux états résistifs de la jonction tunnel super-paramagnétique MTJ. Le transistor de polarisation Tₚₒₗ est monté en série avec la jonction tunnel magnétique MTJ entre un nœud d'alimentation fournissant la tension d'alimentation VDD et la masse électrique GND. L'augmentation du courant de polarisation Ic induit l'augmentation de la probabilité P(1) d'avoir un état résistif haut AP (équivalent à un bit « 1 »). Inversement, la diminution du courant de polarisation Ic induit l'augmentation de la probabilité P(0) d'avoir un état résistif bas P (équivalent à un bit « 0 »). Le contrôle du courant de polarisation Ic est réalisé par l'application d'une tension d'entrée Vᵢₙ sur la grille du transistor de polarisation Tₚₒₗ. Le circuit de contrôle CONT est configuré pour appliquer la tension d'entrée Vᵢₙ variable sur la grille du transistor de polarisation Tₚₒₗ. La plage de variation de la tension d'entrée Vᵢₙ est choisie telle que le transistor de polarisation Tₚₒₗ fonctionne sous régime ohmique pour assurer un comportement linéaire du générateur.

Le nœud commun entre le transistor de polarisation Tₚₒₗ et la jonction tunnel magnétique MTJ forme un premier nœud de détection NC1. Le potentiel V_{DIV} du premier nœud de détection NC1 varie en créneau selon la chute de tension à travers la jonction tunnel magnétique MTJ qui dépend de la valeur de résistance de ladite jonction. Lorsque la jonction tunnel magnétique MTJ est à un état résistif haut AP, la tension V_{DIV} est à une tension basse, et lorsque la jonction tunnel magnétique MTJ est à un état résistif bas P, la tension V_{DIV} est à une tension haute.

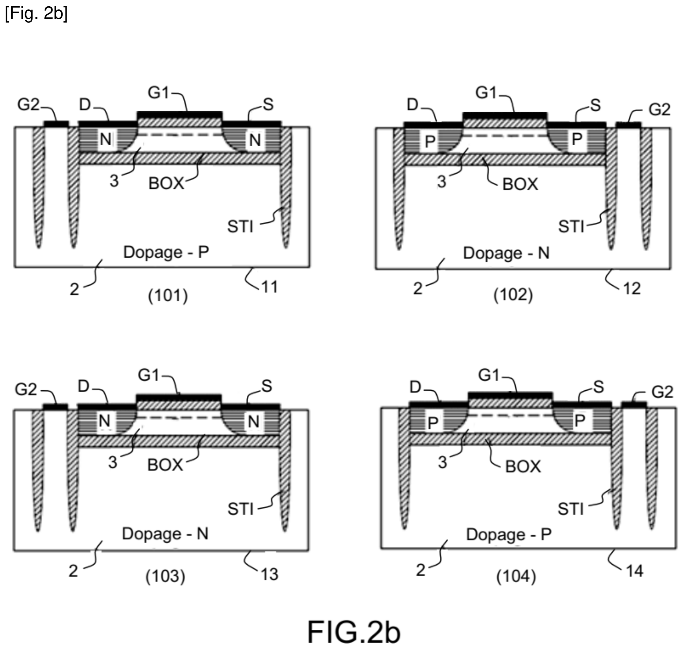

Le circuit de détection DET comprend un premier inverseur INV1 formé par un premier transistor T_{INV1,N} de type NMOS et un second transistor T_{INV1,P} de type PMOS monté en série entre la masse et le nœud d'alimentation fournissant VDD. Dans l'exemple illustré, le circuit de détection DET est constitué de l'inverseur INV1. L'entrée e_{det} correspond à l'entrée de l'inverseur INV1 et la sortie s_{det} correspond à la sortie de l'inverseur INV1. Le premier et le second transistor T_{INV1,N},T_{INV1,P} sont chacun réalisés sur une couche d'isolant enterrée dans le substrat de type SOI, acronyme en anglais de Silicon-on-Insulator pouvant être traduit en « silicium sur isolant », et plus avantageusement sur un substrat de type FDSOI (acronyme de Fully Depleted Silicon-on-Insulator) pouvant être traduit en « silicium sur isolant totalement déserté ». Pour mieux comprendre l'invention, la figure 2b illustre des vues en coupe de l'implémentation de quatre transistors différents de type FDSOI. Le schéma 101 est un transistor 11 de type NMOS à tension de seuil régulière (RVT pour Regular VT). Le schéma 102 est un transistor FDSOI 12 de type PMOS à tension de seuil régulière (PMOS-RVT). Le schéma 103 est un transistor FDSOI 13 de type NMOS à basse tension de seuil LVT (LVT pour Low VT). Le schéma 104 est un transistor FDSOI 14 de type PMOS à basse tension de seuil (PMOS-LVT). Le transistor 11 dans le schéma 101 de type NMOS-RVT selon la technologie FDSOI est réalisé sur un substrat 2 à base de semi-conducteur dopé P. Une couche de matériau diélectrique isolant, généralement un oxyde noté BOX, vient séparer l'ensemble composé des zones dopées N formant le drain D et la source S et la région du semi-conducteur 3 contenant le canal de conduction du reste du substrat 2. Une grille de commande G1 est obtenue par superposition d'une couche d'oxyde et d'une couche métallique sur la région 3 du canal de conduction de manière semblable à une grille d'un transistor MOS sur un substrat de semi-conducteur massif. Des tranchées latérales d'isolation STI en oxyde sont rajoutées de chaque côté du transistor 11 pour assurer une isolation électrique du composant. Des couches de matériau conducteur, généralement métalliques, sont déposées sur la grille G1, le drain D et la source S pour permettre la connexion électrique à ces terminaux. De plus, un terminal supplémentaire G2 est rajouté par le dépôt d'une couche métallique sur la région délimitée par deux tranchées latérales d'isolation STI adjacentes au transistor 11. L'application d'une tension électrique sur le terminal G2 permet de polariser la couche d'oxyde enterrée BOX qui joue le rôle d'une grille arrière. Cela permet de faire varier ainsi la tension de seuil Vₜₕ du transistor 1. Cette opération est communément désignée par le terme anglais « Back-Biasing ». Le transistor 12 de type PMOS-RVT du schéma 102 présente exactement la même structure que celui du schéma 101 sauf pour la distribution du dopage puisqu'il s'agit d'un transistor PMOS. Le substrat 2 est dopé N, le drain D et la source S sont dopés P. Concernant le transistor 13 de type NMOS-LVT, la seule différence avec le transistor 11 du schéma 101 est l'inversion du type de dopage du substrat 2 dopé N. Concernant le transistor 14 de type PMOS-LVT, la seule différence avec le transistor 12 du schéma 102 est l'inversion du type de dopage du substrat 2 dopé P. De manière générale, l'invention est réalisable par des transistors de type SOI ou par tout transistor ayant une couche d'isolant enterrée dans le substrat dont la conductance peut être contrôlée via une grille arrière connectée à la couche d'isolant enterrée.

Dans le générateur D1 de bit probabiliste selon l'invention, le premier transistor T_{INV1,N} comprend ainsi, une grille avant G_{1,N} et une grille arrière G_{2,N} et le second transistor T_{INV1,P} comprend une grille avant G_{1,P} et une grille arrière G_{2,P}. Les deux grilles avant G_{1,N} et G_{1,P} sont interconnectées et reçoivent directement le signal V_{DIV} correspondant au potentiel du premier nœud de détection NC1. Les grilles arrière G_{2,N},G_{2,P} des transistors de l'inverseur INV1 reçoivent une tension de commande V_{cmd} générée par le circuit de contrôle CONT. Le circuit de détection DET est configurable selon une première configuration CONF1 et une seconde configuration CONF2. Lorsque la première configuration CONF1 est choisie, la sortie s_{det} du circuit de détection DET est forcée à une tension choisie parmi la tension d'alimentation VDD ou à la masse électrique. La première configuration CONF1 correspond à une opération de « clamping » du générateur de bits probabiliste à un état logique choisi parmi 1 ou 0. L'opération de « clamping » donne une valeur déterministe et non probabiliste avec une probabilité de « 1 » ou de « 0 » égale à 100%. Lorsque la première configuration CONF1 est choisie, le circuit de détection DET est configuré pour générer un signal de détection Vₒᵤₜ fixe indépendamment des variations aléatoires de l'état résistif de la jonction tunnel magnétique MTJ. La seconde configuration CONF2 correspond à un fonctionnement de génération de bits probabiliste dans lequel le circuit de détection DET est configuré pour générer un signal de détection Vₒᵤₜ variable selon l'état résistif de la jonction tunnel magnétique MTJ à partir du potentiel V_{DIV} du premier nœud de détection NC1.

Lorsque la première configuration CONF1 est choisie, le circuit de contrôle CONT est configuré pour appliquer une tension de commande V_{cmd} non-nulle sur la grille arrière du premier et du second transistor T_{INV1,N}, T_{INV1,P} pour fixer le signal de détection Vₒᵤₜ à la sortie du circuit de détection DET à la masse électrique GND ou à la tension du nœud d'alimentation VDD. Lorsque la tension de commande V_{cmd} est négative, la tension de seuil V_{th,N} du premier transistor T_{INV1,N} augmente et la tension de seuil V_{th,P} du second transistor T_{INV1,P} augmente. L'augmentation des tensions de seuil V_{th,N} et V_{th,P} induit une diminution du seuil de basculement du premier inverseur INV1. La diminution du seuil de basculement du premier inverseur INV1 engendre la fixation de la sortie de l'inverseur INV1 à la tension du nœud d'alimentation VDD lorsque l'amplitude de cette diminution est suffisante. Ainsi, il est possible de fixer le signal de détection Vₒᵤₜ à un état logique haut par application d'une tension de commande V_{cmd} négative sur les grilles arrière G_{2,N},G_{2,P} des transistors T_{INV1,N}, T_{INV1,p}. Inversement, lorsque la tension de commande V_{cmd} est positive, la tension de seuil V_{th,N} du premier transistor T_{INV1,N} diminue et la tension de seuil V_{th,P} du second transistor T_{INV1,P} diminue. La diminution des tensions de seuil V_{th,N} et V_{th,P} induit une augmentation du seuil de basculement du premier inverseur INV1. L'augmentation du seuil de basculement du premier inverseur INV1 engendre la fixation de la sortie de l'inverseur INV1 à la masse électrique lorsque l'amplitude de cette diminution est suffisante. Ainsi, il est possible de fixer le signal de détection Vₒᵤₜ du circuit de détection DET à un état logique bas par application d'une tension de commande V_{cmd} positive sur les grilles arrière G_{2,N},G_{2,P} des transistors T_{INV1,N}, T_{INV1,P}.

Alternativement, la tension de commande V_{cmd} est appliquée uniquement sur la grille arrière G_{2,N} du premier transistor T_{INV1,N}. Lorsque la tension de commande V_{cmd} est positive, le signal de détection Vₒᵤₜ est forcé à la masse électrique (clamping à l'état logique « 0 »). Lorsque la tension de commande V_{cmd} est négative, le signal de détection Vₒᵤₜ est forcé à la tension d'alimentation VDD (clamping à l'état logique « 1 »).

Alternativement, la tension de commande V_{cmd} est appliquée uniquement sur la grille arrière G_{2,P} du second transistor T_{INV1,P}. Lorsque la tension de commande V_{cmd} est positive, le signal de détection Vₒᵤₜ est forcé à la masse électrique (clamping à l'état logique « 0 »). Lorsque la tension de commande V_{cmd} est négative, le signal de détection Vₒᵤₜ est forcé à la tension d'alimentation VDD (clamping à l'état logique « 1 »).

Plus généralement, le générateur D1 de bit probabiliste selon l'invention permet de forcer sa sortie à un état logique prédéterminé avec une probabilité de 100% sans ajouter des composants supplémentaires ni augmenter la taille du circuit. L'opération de « clamping » est réalisée en pilotant le seuil de basculement du premier inverseur INV1 par application de la tension de commande V_{cmd} non nulle sur la grille arrière d'au moins un transistor dudit inverseur INV1. L'utilisation des transistors de type FDSOI pour implémenter l'inverseur INV1 est avantageuse car elle permet un contrôle plus maitrisé du seuil de basculement de l'inverseur et ainsi de la sortie du générateur D1. L'application simultanée de la tension de commande V_{cmd} sur les eux transistors T_{INV1,N}, T_{INV1,P} permet d'assurer la dérive du seuil de commutation de l'inverseur INV1 vers la tension d'alimentation VDD ou la masse électrique GND et ainsi éviter le risque de fluctuations non voulues lors d'une opération de « clamping ».

Lorsque la seconde configuration CONF2 est choisie, la tension de commande V_{cmd} est nulle et l'inverseur INV1 fonctionne avec un seuil de basculement compris entre la valeur maximale du potentiel V_{DIV,max} du premier nœud de détection NC1 et la valeur minimale du potentiel V_{DIV,min} du premier nœud de détection NC1. Le circuit de détection DET est alors configuré pour générer un signal de détection Vₒᵤₜ qui reproduit les variations du potentiel du premier nœud de détection NC1. Le circuit de détection permet ainsi de détecter les variations de l'état résistif de la jonction sur toute la plage de variation du signal d'entrée Vᵢₙ.

Le circuit calculateur CALC est configuré pour générer un bit probabiliste à partir du signal de détection Vₒᵤₜ en déterminant la proportion de chaque état résistif de la jonction tunnel magnétique MTJ pendant une période prédéterminée. Le circuit calculateur est configuré pour calculer la distribution entre des bits à un état logique haut « 1 » et des bits à un état logique bas « 0 » dans une séquence de bits correspondant au signal de détection Vₒᵤₜ pendant une durée prédéterminée. Par exemple, le circuit calculateur CALC est configuré pour échantillonner le signal de détection Vₒᵤₜ chaque 1ns pendant une période de 10µs. Le nombre de bits à « 1 » (ou des bits à « 0 ») est calculé pendant la période de 10µs, ce qui correspond à un échantillon de 10000 bits logiques pour déterminer la proportion de bits à « 1 » et à « 0 » ce qui correspond au bit probabiliste p-bit = (P(1),P(0)). Lorsque le signal de détection Vₒᵤₜ est fixé à VDD, le calculateur génère un bit probabiliste p-bit = (100%,0%). Lorsque le signal de détection Vₒᵤₜ est fixé à 0V, le calculateur génère un bit probabiliste p-bit = (0%,100%).

Alternativement, le circuit calculateur CALC est configuré pour calculer la moyenne du signal de détection s1 sur la durée de la période. La moyenne est proportionnelle au nombre de bits égal à « 1 » sur la période échantillonnée.

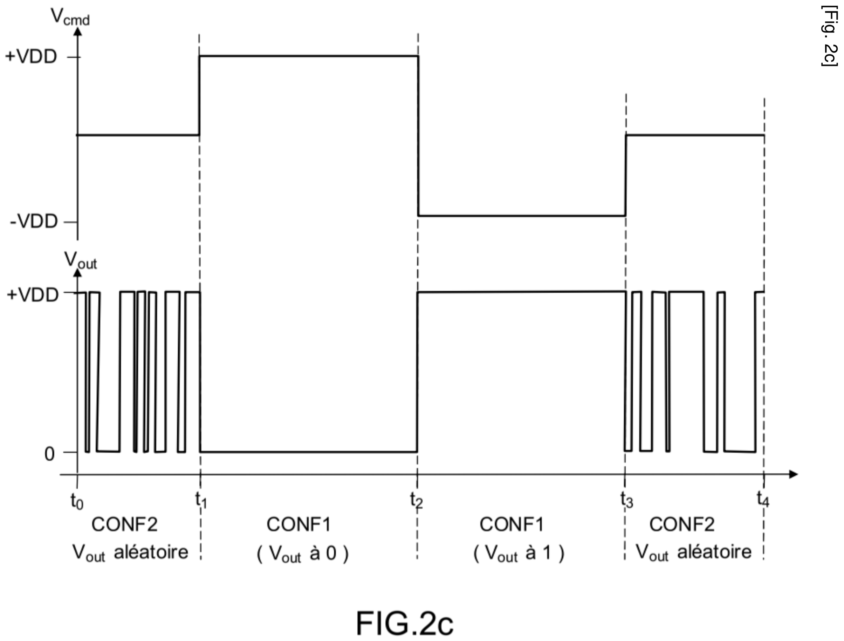

La figure 2c illustre la variation du signal de détection Vₒᵤₜ du générateur de bit probabiliste selon un premier mode de réalisation de l'invention en réponse à une variation de la tension de commande V_{cmd}. Pendant la période t0 à t1, la tension de commande V_{cmd} est maintenue à 0 par le circuit de contrôle CONT. Le générateur D1 fonctionne selon la seconde configuration CONF2 correspondant à un régime de fluctuations aléatoires observé sur le signal de détection Vₒᵤₜ. Pendant la période t1 à t2, la tension de commande V_{cmd} est maintenue à +VDD par le circuit de contrôle CONT. Le générateur D1 fonctionne selon la première configuration CONF1 correspondant à un signal de détection Vₒᵤₜ forcé à la masse électrique. Pendant la période t2 à t3, la tension de commande V_{cmd} est maintenue à -VDD par le circuit de contrôle CONT. Le générateur D1 fonctionne selon la première configuration CONF1 correspondant à un signal de détection Vₒᵤₜ forcé à VDD. Pendant la période t3 à t4, la tension de commande V_{cmd} est maintenue à 0 par le circuit de contrôle CONT. Le générateur D1 fonctionne selon la seconde configuration CONF2 correspondant à un régime de fluctuations aléatoires observé sur le signal de détection Vₒᵤₜ.

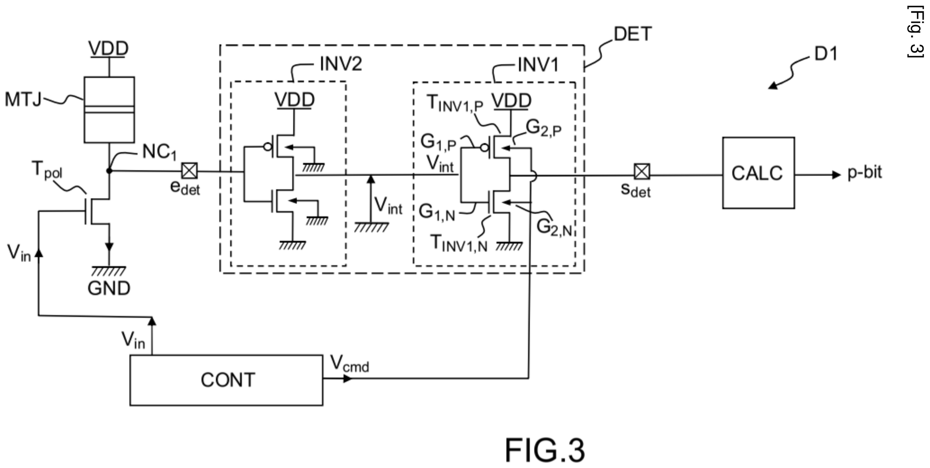

La figure 3 illustre un générateur D1 de bit probabiliste selon un deuxième mode de réalisation de l'invention. Le deuxième mode de réalisation reprend les mêmes caractéristiques et avantages techniques détaillés pour le premier mode de réalisation. Le circuit de détection DET dans le second mode de réalisation comprend en outre un second inverseur INV2 monté en amont du premier inverseur INV1. L'entrée du second inverseur INV2 est connectée au premier nœud de détection NC1 et sa sortie est connectée aux grilles avant G_{1,N},G_{1,P} des transistors T_{INV1,N}, T_{INV1,P} du premier inverseur INV1. Le second inverseur INV2 génère une tension intermédiaire Vᵢₙₜ à partir du potentiel V_{DIV} du premier nœud de détection NC1. Les substrats des transistors qui forment le second inverseur INV2 sont connectés à la masse électrique pour obtenir un seuil de basculement permettant de détecter les variations du potentiel V_{DIV}. Le second inverseur INV2 est dimensionné de manière à détecter à son entrée et à amplifier à sa sortie les petites variations du potentiel V_{DIV}. Cela permet de manière avantageuse une détection plus précise des fluctuations lorsque la seconde configuration CONF2 est choisie. Par ailleurs, le second inverseur INV2 placé en amont du premier inverseur INV1 permet une polarisation plus stable des transistors T_{INV1,N}, T_{INV1,P} du premier inverseur INV1.

Selon un aspect particulier du second mode de réalisation, le circuit de détection DET comprend une chaine formée de N inverseurs, avec N un entier naturel supérieur à 1. La chaine d'inverseurs comprend au moins le premier inverseur INV1 réalisé par des transistors T_{INV1,N}, T_{INV1,P} dont les tensions de seuil Vₜₕ sont commandées par la tension de commande V_{cmd} appliquée sur leurs grilles arrière.

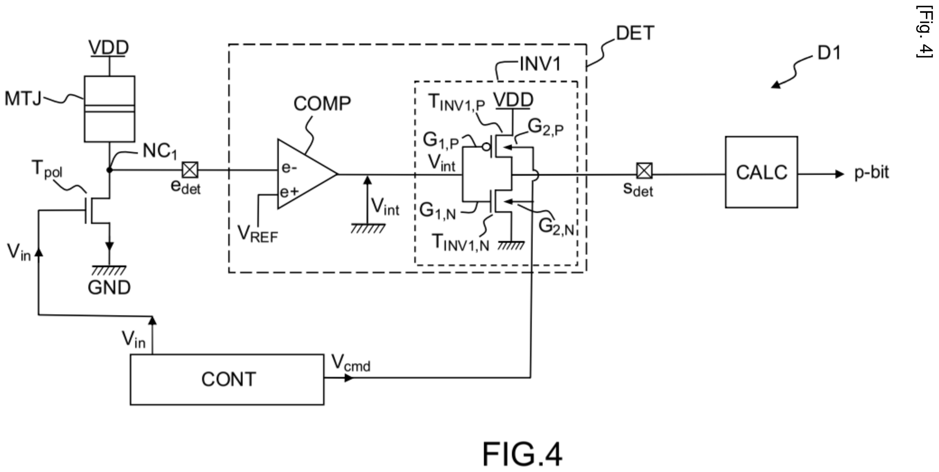

La figure 4 illustre un générateur D1 de bit probabiliste selon un troisième mode de réalisation de l'invention. Le troisième mode de réalisation reprend les mêmes caractéristiques et avantages techniques détaillés pour le premier mode de réalisation. Le circuit de détection DET dans le troisième mode de réalisation comprend en outre un comparateur COMP monté en amont du premier inverseur INV1. Le comparateur COMP comprend une première entrée e- connectée au nœud de détection NC1 ; et une seconde entrée recevant une tension de référence V_{REF}. Dans l'exemple illustré et de manière non-limitative, la première entrée e- est l'entrée inverseuse du comparateur et la seconde entrée e+ est l'entrée non-inverseuse. Ainsi, lorsque la jonction tunnel magnétique MTJ est à un état résistif haut AP, la tension reçue par la première entrée du comparateur est inférieure à la tension de référence V_{REF} et le comparateur génère un signal intermédiaire Vᵢₙₜ égal à VDD équivalent à un bit égal à « 1 ». Lorsque la jonction tunnel magnétique MTJ est à un état résistif bas P, la tension reçue par la première entrée du comparateur est supérieure à la tension de référence V_{REF} et le comparateur génère un signal intermédiaire Vᵢₙₜ égal à 0, équivalent à un bit égal à « 0 ». La sortie du comparateur COMP est connectée aux grilles avant G_{1,N},G_{1,P} des transistors T_{INV1,N}, T_{INV1,P} du premier inverseur INV1. Le comparateur COMP est dimensionné de manière à détecter à son entrée et à amplifier à sa sortie les petites variations du potentiel V_{DIV}. Cela permet de manière avantageuse une détection plus précise des fluctuations lorsque la seconde configuration CONF2 est choisie. Par ailleurs, lorsque la première configuration CONF1 est choisie « opération de clamping », il est possible de baisser ou d'augmenter la valeur de la tension de référence V_{REF} de manière à fixer Vᵢₙₜ à une tension fixe. La combinaison du comparateur COMP avec le contrôle des grilles arrière des transistors du premier inverseur INV1 permet d'augmenter la fiabilité de l'opération de clamping de la sortie du générateur D1 selon l'invention.

Selon un aspect particulier du troisième mode de réalisation, le circuit de détection DET comprend une chaine formée de N inverseurs, avec N un entier naturel supérieur à 1. La chaine d'inverseurs comprend au moins le comparateur COMP et le premier inverseur INV1 réalisé par des transistors T_{INV1,N}, T_{INV1,P} déjà décrit.

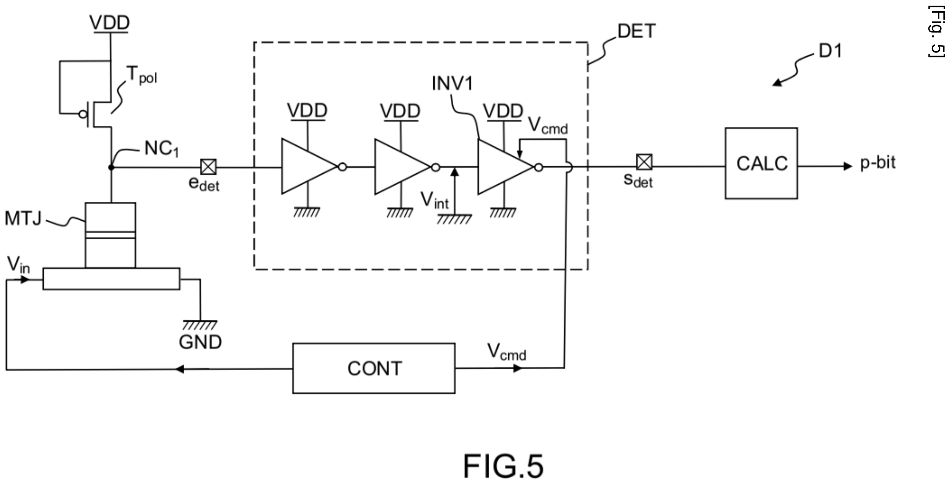

La figure 5 illustre un générateur D1 de bit probabiliste selon un quatrième mode de réalisation de l'invention. Le quatrième mode de réalisation reprend les mêmes caractéristiques et avantages techniques détaillés pour les modes de réalisation précédents. Dans le générateur D1 selon le quatrième mode de réalisation, la jonction tunnel magnétique MTJ est disposée sur une piste d'écriture SOT en un matériau à effet Hall de spin ou un matériau à effet Hall orbital. L'interface entre la jonction tunnel magnétique MTJ et la piste d'écriture SOT est du côté de la couche ferromagnétique libre. La direction de l'empilement formant la jonction tunnel magnétique MTJ est orthogonale au plan formé par la couche formant la piste d'écriture SOT. La piste d'écriture SOT est réalisée en un matériau à effet hall de spin (dénommé aussi matériau à effet de couple spin-orbite), par exemple le tungstène en phase béta ou l'antimoniure de bismuth ou un empilement de deux couches l'une en tantale et l'autre en tungstène ou un alliage BiSbTe. Les moyens de contrôle génèrent un courant d'écriture Iᵢₙ à travers la piste d'écriture SOT selon une direction. Cela induit des courants de spin qui interagissent avec la couche ferromagnétique libre. Cette interaction permet un contrôle de la direction de polarisation magnétique dans la couche ferromagnétique libre de la jonction MTJ selon la direction du courant d'écriture dans la piste d'écriture SOT. Le contrôle de la direction de polarisation magnétique dans la couche ferromagnétique libre permet de modifier la résistance électrique R(MTJ) de la jonction tunnel magnétique MTJ sans y injecter un courant d'écriture, ce qui augmente considérablement la robustesse du dispositif spintronique. Le circuit de détection DET comprend au moins le premier inverseur INV1 déjà décrit pour obtenir un fonctionnement selon la première configuration CONF1 (sortie forcée avec probabilité de 100%) ou bien un fonctionnement selon la seconde configuration CONF2 (fluctuation stochastique de la sortie).

Le dispositif spintronique décrit dans l'invention utilise les propriétés aléatoires d'une jonction tunnel magnétique (MTJ) pour générer des bits aléatoires ou pseudo-aléatoires avec une distribution maîtrisée, ou pour produire une sortie fixée sur un état logique prédéfini. Contrairement aux générateurs classiques, ce dispositif adopte une architecture de détection innovante qui permet de changer de configuration sans nécessiter de composants supplémentaires. Cette approche facilite l'exécution de calculs impliquant des générateurs stochastiques dans un réseau de plusieurs centaines de générateurs probabilistes, tout en limitant la taille et la consommation énergétique du calculateur stochastique.

## Revendications

1. Dispositif spintronique (D1) comprenant :
- une jonction tunnel magnétique (MTJ) ayant une résistance qui fluctue entre au moins deux états résistifs distincts (P, AP) selon sa magnétisation ;
- un transistor de polarisation (Tₚₒₗ) monté en série avec la jonction tunnel magnétique (MTJ) ; le nœud commun entre le transistor de polarisation (Tₚₒₗ) et la jonction tunnel magnétique (MTJ) constituant un premier nœud de détection (NC1) ;
- un circuit de détection (DET) ayant une entrée (e_{det}) connectée au premier nœud de détection (NC1) et une sortie (s_{det}) pour générer un signal de détection (Vₒᵤₜ) ; le circuit de détection (DET) comprenant au moins un premier inverseur (INV1) comprenant un premier transistor NMOS (T_{INV1,N}) et un second transistor PMOS (T_{INV1,P}) montés en série entre la masse électrique (GND) et un nœud d'alimentation fournissant une tension d'alimentation (VDD) , et ayant chacun :
∘ une grille avant (G_{1,N},G_{1,P}) ;
∘ une grille arrière (G_{2,N},G_{2,P}) formée par une couche isolante (BOX) enterrée dans un substrat semi-conducteur (2) ;
les grilles avant (G_{1,N} ,G_{1,P}) du premier et du second transistors (T_{INV1,N} T_{INV1,P}) recevant le potentiel (V_{DIV}) du premier nœud de détection (NC1) ou un signal intermédiaire (Vᵢₙₜ) généré à partir du potentiel (V_{DIV}) du premier nœud de détection (NC1) ;
- un circuit de contrôle (CONT) configuré , selon une première configuration (CONF1), pour appliquer une tension de commande (V_{cmd}) non-nulle sur la grille arrière (G_{2,N},G_{2,P}) d'au moins l'un parmi le premier ou le second transistor (T_{INV1,N}, T_{INV1,P}) pour fixer le signal de détection (Vₒᵤₜ) à la masse électrique (GND) ou à la tension du nœud d'alimentation (VDD) selon le signe de la tension de commande (V_{cmd}).

2. Dispositif spintronique (D1) selon la revendication 1 dans lequel le circuit de contrôle (CONT) est configuré en outre, selon une seconde configuration (CONF2), pour appliquer une tension de commande (V_{cmd}) nulle sur la grille arrière (G_{2,N},G_{2,P}) d'au moins l'un parmi le premier ou le second transistor (T_{INV1,N}, T_{INV1,P}) de sorte que signal de détection (Vₒᵤₜ) varie avec les fluctuations de la résistance de la jonction tunnel magnétique.

3. Dispositif spintronique (D1) selon l'une quelconque des revendications 1 ou 2 dans lequel le premier transistor (T_{INV1,N},) et le second transistor (T_{INV1,P}) sont de type « silicium sur isolant totalement déserté ».

4. Dispositif spintronique (D1) selon l'une quelconque des revendications 1 à 3 dans lequel le circuit de contrôle (CONT) est configuré pour appliquer la tension de commande (V_{cmd}) simultanément sur les grilles arrière (G_{2,N},G_{2,P}) du premier transistor (T_{INV1,N},) et du second transistor (T_{INV1,P}).

5. Dispositif spintronique (D1) selon l'une quelconque des revendications 1 à 4 dans lequel le circuit de détection (DET) comprend une chaine d'une pluralité d'inverseurs (INV1,INV2,INV3) ; ladite chaine comprenant le premier inverseur (INV1).

6. Dispositif spintronique (D1) selon l'une quelconque des revendications 1 à 4 dans lequel le circuit de détection comprend un comparateur (COMP) ayant une première entrée connectée au premier nœud de détection (NC1) et une seconde entrée destinée à recevoir une tension de référence (V_{REF}) et un nœud de sortie connecté aux grilles avant (G_{1,N},G_{1,P}) du premier et du second transistor (T_{INV1,N} TINV1,P).

7. Dispositif spintronique (D1) selon l'une quelconque des revendications 1 à 4 dans lequel le premier nœud de détection (NC1) est connecté aux grilles avant (G_{1,N},G_{1,P}) du premier et du second transistors (T_{INV1,N} T_{INV1,P}).

8. Dispositif spintronique (D1) selon l'une quelconque des revendications 1 à 7 comprenant en outre un circuit calculateur (CALC) configuré pour générer un bit probabiliste à partir du signal de détection (Vₒᵤₜ) par échantillonnage ou par calcul de moyenne en déterminant la proportion de chaque état résistifs de la jonction tunnel magnétique (MTJ) pendant une période prédéterminée.

9. Dispositif spintronique (D1) selon l'une quelconque des revendications 1 à 8 dans lequel la jonction tunnel magnétique (MTJ) est une jonction tunnel super-paramagnétique.

10. Dispositif spintronique (D1) selon l'une quelconque des revendications 1 à 9 dans lequel la jonction tunnel magnétique (MTJ) est disposée sur une piste d'écriture (SOT) en un matériau à effet Hall de spin ou un matériau à effet Hall orbital.

11. Dispositif spintronique (D1) selon l'une quelconque des revendications 1 à 10 dans lequel la jonction tunnel magnétique (MTJ) comprend :
- une première couche (11) ferromagnétique de référence dans laquelle la direction de la polarisation magnétique est fixe ;
- une seconde couche (13) ferromagnétique dans laquelle la direction de la polarisation magnétique est variable ;
- une couche barrière tunnel (12) d'oxyde confinée entre la première et la seconde couche ferromagnétique (11,13).

12. Dispositif spintronique (D1) selon la revendication 11 dans lequel l'épaisseur de la seconde couche (13) est inférieure à 100 nm.

13. Dispositif spintronique (D1) selon l'une quelconque des revendications 11 ou 12 dans lequel le diamètre de la jonction tunnel magnétique (MTJ) est inférieur à 10 nm.

14. Calculateur stochastique comprenant un réseau d'une pluralité de générateurs (D1) de bit probabiliste (p-bit) interconnectés, le réseau comprenant au moins un générateur (D1) de bit probabiliste (p-bit) réalisé par le dispositif spintronique (D1) selon l'une quelconque des revendications 1 à 13.
